(19) Europäisches Patentamt

European Patent Office

Office européen des brevets

(11) **EP 1 216 493 B1**

(12) **FASCICULE DE BREVET EUROPEEN**

(45) Date de publication et mention
de la délivrance du brevet:
**23.07.2003 Bulletin 2003/30**

(21) Numéro de dépôt: **00962606.0**

(22) Date de dépôt: **12.09.2000**

(51) Int Cl.⁷: **H01P 5/16**

(86) Numéro de dépôt international:
**PCT/FR00/02507**

(87) Numéro de publication internationale:
**WO 01/020710 (22.03.2001 Gazette 2001/12)**

(54) **DIVISEUR DE PUISSANCE POUR DISPOSITIF A PLASMA**

LEISTUNGSVERTEILER IN EINER PLASMAVORRICHTUNG

POWER SPLITTER FOR PLASMA DEVICE

(84) Etats contractants désignés:
**AT BE CH CY DE DK ES FI FR GB GR IE IT LI LU
MC NL PT SE**

(30) Priorité: **13.09.1999 FR 9911422**

(43) Date de publication de la demande:
**26.06.2002 Bulletin 2002/26**

(73) Titulaires:
• **CENTRE NATIONAL DE
LA RECHERCHE SCIENTIFIQUE (CNRS)**
**75794 Paris Cedex 16 (FR)**
• **Universite de Montreal**
**Montréal, Québec H3C 3J7 (CA)**
• **Metal Process**
**77144 Montevrain (FR)**

(72) Inventeurs:
• **PELLETIER, Jacques**
**38400 St Martin d'Heres (FR)**
• **LACOSTE, Ana**
**F-38950 St Martin le Vinoux (FR)**

• **LAGARDE, Thierry, Léon**
**F-38100 Grenoble (FR)**
• **MOISAN, Michel**
**Montreal, Quebec H2V 2Z1 (CA)**
• **ARNAL, Yves, Alban-Marie**
**F-38320 Poisat (FR)**
• **ZAKRZEWSKI, Zenon**
**PL-80-461 Gdansk (PL)**

(74) Mandataire: **Texier, Christian
Cabinet Régimbeau
20, rue de Chazelles
75847 Paris cedex 17 (FR)**

(56) Documents cités:
**US-A- 4 847 460          US-A- 5 517 085**

• **PATENT ABSTRACTS OF JAPAN vol. 16, no. 219
(C-0943), 22 mai 1992 (1992-05-22) & JP 04
041675 A (MATSUSHITA ELECTRIC IND. CO.
LTD.), 12 février 1992 (1992-02-12)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne le domaine des dispositifs micro-ondes.

Plus précisément la présente invention concerne le domaine des dispositifs comprenant plusieurs sources élémentaires micro-ondes alimentées à partir d'un générateur commun.

La présente invention peut trouver notamment application dans la production de plasma à partir d'un nombre donné de sources élémentaires de plasma alimentées en micro-onde depuis un unique générateur de puissance.

Ces sources élémentaires peuvent être, soit indépendantes dans une même enceinte (l'objectif étant par exemple de contourner les limites physiques ou technologiques de la puissance micro-onde maximale qu'il est possible d'appliquer sur une source de plasma unique), soit réparties dans une même enceinte afin de permettre l'extension d'échelle nécessaire à une application visée. D'une manière générale, les domaines d'applications des sources de plasma multiples peuvent couvrir non seulement l'ensemble des domaines déjà couverts par la mise en oeuvre des sources de plasma uniques, mais aussi des domaines nouveaux non envisageables avec des sources unitaires (par exemple pour des raisons d'uniformité, cadences, etc.).

L'invention concerne l'ensemble des plasmas et décharges micro-ondes, quel que soit le domaine de pression, la fréquence micro-onde, la nature ou la configuration de l'applicateur micro-onde, la présence ou l'absence de champ magnétique.

Cependant l'invention n'est pas limitée au domaine des plasmas. Elle peut par exemple également s'appliquer pour des opérations de collage, de séchage ou de vulcanisation à partir de postes multiples et plus généralement pour toute opération où l'impédance du système peut varier en fonction du temps d'un poste à l'autre.

Le domaine des micro-ondes a déjà fait l'objet de nombreuses recherches.

L'alimentation de plusieurs sources élémentaires à partir d'un générateur commun, en particulier, a déjà fait l'objet de plusieurs propositions.

Pour diviser la puissance micro-onde délivrée par un générateur unique, on peut utiliser des cascades de coupleurs 3 dB (division par 2) réalisées par exemple à partir de guides d'ondes rectangulaires. Cette solution, bien que souvent très encombrante, permet de réaliser des divisions de puissance par $N = 2^k$, où k représente le nombre de niveaux successifs de la cascade. On peut ainsi diviser la puissance micro-onde par 2, 4, 8, 16, 32, etc. Une transition adaptée guide - coaxial en bout de chaque guide permet en outre de transporter la puissance micro-onde à l'aide de câbles coaxiaux munis de connecteurs standards.

Une autre solution couramment utilisée est de prélever la puissance micro-onde soit dans une cavité, soit dans un guide, soit dans un résonateur en anneau, dans lesquels on établit des ondes stationnaires, par des antennes disposées aux ventres de champ électrique (zones de champ électrique maximum). Cette solution suppose en général que chaque source élémentaire de plasma se comporte comme une impédance adaptée, autrement dit qu'elle absorbe la totalité de la puissance micro-onde prélevée. Avec un tel dispositif, il est alors possible de fournir une puissance micro-onde prédéterminée à chaque source élémentaire.

Le document D1 US-A-5 517 085 divulgue un dispositif comprenant un résonateur en anneau avec un guide rectangulaire fonctionnant dans le mode $TE_{10}$, dans lequel on établit des ondes stationnaires, et on prélève la puissance micro-onde par des prises disposées dans le guide consistant en des antennes à fente.

Cependant les dispositifs jusqu'ici proposés ne donnent pas totalement satisfaction.

L'une des difficultés de la division de puissance micro-onde en vue de l'alimentation de sources de plasma est que, de manière générale, une source de plasma ne se comporte pas comme une charge adaptée. En effet, l'impédance ramenée à l'entrée d'une source de plasma résultant de la combinaison de l'impédance d'entrée de l'applicateur et de l'impédance du plasma ramenée à cette entrée ne correspond généralement pas à une charge adaptée, c'est-à-dire une charge purement résistive et égale à l'impédance caractéristique de la ligne d'alimentation micro-onde. Au contraire, on peut se trouver confronté suivant le type de décharge, les conditions de décharge, et la puissance absorbée, à des valeurs d'impédance complexes à l'entrée de la source plasma qui varient de zéro à l'infini.

Dans le cas de plusieurs sources plasma alimentées par un même générateur micro-onde, il s'ajoute le problème de l'influence de l'impédance d'une source sur l'ensemble des autres sources en l'absence d'un découplage suffisant (typiquement > 20 dB) entre les lignes d'alimentation des différentes sources en micro-ondes.

Ainsi, immédiatement avant l'allumage, l'impédance à l'entrée de la source est généralement beaucoup plus importante que celle correspondant au régime permanent de la décharge. Outre cette variation d'impédance pour une source donnée au moment de l'allumage, la distribution de puissance est également affectée par l'allumage non simultané des différentes sources de plasma. Par conséquent, la mise en route d'un ensemble de sources plasma oblige à faire face à des déséquilibres importants des puissances transmises aux sources de plasma et à l'introduction de puissances réfléchies importantes dans le circuit.

Ces déséquilibres, qui provoquent des niveaux de puissance réfléchie très élevés, peuvent empêcher la mise en route du plasma dans les sources nécessitant une densité de plasma minimum, donc une puissance transmise minimum comme par exemple dans les plasmas à ondes de surface.

Une autre difficulté entraînant un déséquilibre d'impédance est liée aux plasmas dont la densité de plasma se trouve, au contraire, limitée à une valeur supérieure, par exemple la densité critique, comme dans les plasmas utilisant la résonance cyclotronique électronique répartie. Dans ce cas, toute puissance incidente supérieure à la valeur assurant la densité critique est réfléchie à l'entrée de la source et se retrouve dans le circuit de distribution des micro-ondes.

En outre, on peut aussi rencontrer des déséquilibres d'impédance en cours de fonctionnement, par exemple en cas de défaillance de l'une des sources, ou à la suite d'une variation, intentionnelle ou non, des conditions opératoires (composition du gaz, débit, pression, densité du plasma, polarisation radiofréquence, etc.) lors de procédés à plusieurs séquences.

Finalement, dans le cas de plusieurs sources de plasma fonctionnant dans la même enceinte, les interférences entre applicateurs conduisent aussi à des niveaux de puissance réfléchie pouvant perturber la répartition de puissance recherchée.

Ainsi, les solutions de division de puissance micro-onde classiques, soit sont trop encombrantes (cascades de coupleurs 3 dB), soit ne permettent qu'une division suivant des nombres imposés n = $2^k$, soit nécessitent une impédance adaptée, ce qui n'est pas le cas d'une source de plasma.

La présente invention a pour but de perfectionner les systèmes micro-ondes comprenant plusieurs sources élémentaires alimentées à partir d'un générateur commun, afin d'éliminer les inconvénients de la technique antérieure.

Ce but est atteint dans le cadre de la présente invention grâce à un système comprenant :

- un générateur de micro-ondes,
- un guide rectangulaire couplé au générateur, adapté pour fonctionner en mode fondamental ($H_{10}$) ou transversal électrique ($TE_{10}$), et associé à des moyens assurant un régime d'ondes stationnaires,
- une pluralité de prises de puissance disposées dans le guide au niveau des zones d'amplitude maximale de l'une des composantes du champ électromagnétique pour assurer une division de la puissance du générateur, les prises de puissance étant ajustées de telle sorte que la somme de leurs admittances réduites ramenées à l'entrée du diviseur formé par le guide rectangulaire, soit unitaire et
- une pluralité de sources, couplées respectivement à une prise du guide, par l'intermédiaire
- d'un moyen isolateur assurant une transmission de puissance de la prise vers la source, sans réflexion vers la prise et
- d'un dispositif d'adaptation d'impédance de chaque source, situé en aval du moyen isolateur, entre ce dernier et la source associée.

D'autres caractéristiques, buts et avantages de la présente invention apparaîtront à la lecture de la description détaillée qui va suivre et en regard des dessins annexés donnés à titre d'exemples non limitatifs et sur lesquels :

- la figure 1 représente l'évolution de la conductance réduite d'une antenne ramenée à l'entrée du guide, en fonction de la longueur de cette antenne dans le guide,
- les figures 2 et 3 représentent des vues en coupe transversale d'un guide et illustrent deux variantes d'implantation de prises ou antennes, sur celui-ci,
- la figure 4 représente une vue schématique globale d'un dispositif conforme à la présente invention, et
- la figure 5 représente une vue en perspective d'un guide correspondant à un mode de réalisation préférentiel de la présente invention.

Comme on l'a indiqué précédemment, la présente invention fait appel à la combinaison de trois éléments dont le premier 100 assure la division de puissance requise (préférentiellement, mais pas nécessairement l'équipartition selon les besoins), le deuxième 200 assure une transmission de puissance indépendante et sans réflexion à chaque source 400, quelle que soit l'impédance d'entrée présentée par chacune de ces sources 400, et le troisième 300, dispositif d'adaptation d'impédance sur chaque source 400, assure à la puissance ainsi disponible d'être plus ou moins totalement absorbée (par exemple dans le plasma) en fonction des besoins.

Plus précisément encore dans le cadre de l'invention, le diviseur de puissance 100 s'obtient à partir d'un guide d'ondes rectangulaire 110 à partir duquel on effectue un prélèvement de puissance, en général sur un grand côté 112 du guide, en des points 114 distants d'une demi-longueur d'onde dans le guide, soit $\lambda_g/2$.

Cette longueur d'onde $\lambda_g$ répond à la relation :

$$1/\lambda_g^2 = 1/\lambda_0^2 - 1/(2a)^2, \qquad (1)$$

où a est la largeur du grand côté 112 du guide rectangulaire 110 et $\lambda_0$ la longueur d'onde dans le vide, des micro-ondes.

Pour assurer la division de puissance requise, on peut par exemple créer une onde stationnaire d'amplitude constante au moyen d'un plan réflecteur 130 (court-circuit fixe ou mobile) situé à l'extrémité du guide 110 opposée à l'arrivée de puissance micro-onde provenant du générateur 10. La réalisation de cette condition d'ondes stationnaires à amplitude constante implique que le guide d'ondes 110 ne permette la propagation que d'un seul mode.

Ainsi, dans le cadre de la présente invention, le guide 110 est adapté pour fonctionner en mode fondamental $H_{10}$ ou transversal électrique $TE_{10}$.

Dans le cas d'un prélèvement de puissance au moyen d'une antenne électrique, il convient de placer de préférence les antennes 116 au maximum de l'intensité de champ électrique.

Dans le cas d'un prélèvement au moyen d'une antenne 116 magnétique (une boucle), il faut au contraire placer ces antennes 116 au minimum d'intensité de champ électrique (maximum de champ magnétique).

Pour faire en sorte que l'impédance totale présentée à l'entrée du dispositif de division de puissance 100 soit égale à l'impédance caractéristique du guide 110 (impédance réduite unitaire), il faut que la somme des admittances (cas du couplage électrique) réduites de l'ensemble des antennes 116 ramenées à l'entrée du diviseur 100 soit unitaire. Pour arriver à ce résultat, il convient soit d'ajuster la profondeur de pénétration de l'antenne électrique 116 dans le guide 110, soit de déplacer la position des antennes 116 transversalement par rapport à l'axe du guide 110, soit encore de combiner ces deux possibilités. On peut procéder de façon équivalente pour le couplage magnétique.

A titre d'exemple, dans le cas d'une division égale de la puissance micro-onde par N à l'aide d'un couplage électrique, la conductance (partie réelle de l'impédance) réduite (ramenée à l'impédance caractéristique) d'une antenne 116 ramenée à l'entrée du guide a pour expression :

$$g = 1/N \qquad (2)$$

Pour une forme et un diamètre donnés, la longueur de l'antenne 116 doit donc être ajustée de façon à obtenir l'impédance correspondant à la division de puissance N souhaitée.

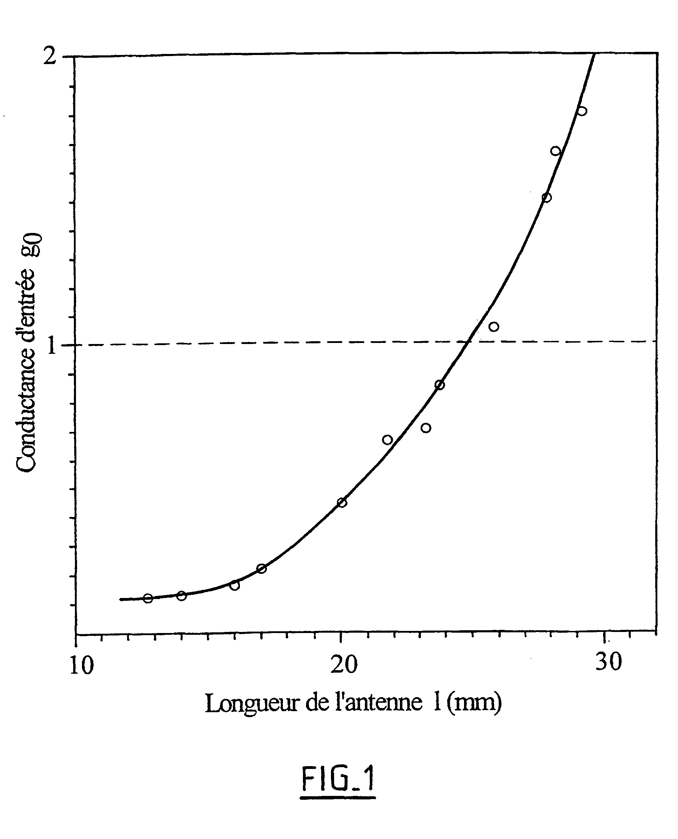

Un exemple d'évolution de conductance en fonction de la longueur de l'antenne 116 est représenté sur la Fig. 1 (pour une antenne de diamètre 3 mm avec une tête à l'extrémité de diamètre 5 mm et d'épaisseur de 2 mm) pour des antennes disposées sur l'axe d'un des grands côtés 112 du guide 110.

Dans le but de réduire la longueur du dispositif 100 qui, dans la configuration décrite ci-dessus, est égale à $N\lambda_g/2$, une variante de l'invention consiste à disposer 2 antennes 116 de part et d'autre de l'axe du grand côté 112 du guide 110 tous les $\lambda_g/2$ comme dans la première configuration présentée. Si $g_0$ est la conductance d'une antenne 116 sur l'axe, sa valeur g à la distance d de l'axe du grand côté 112 du guide 110 vaut :

$$g = g_0 \cos^2 (\pi d/a) \qquad (3)$$

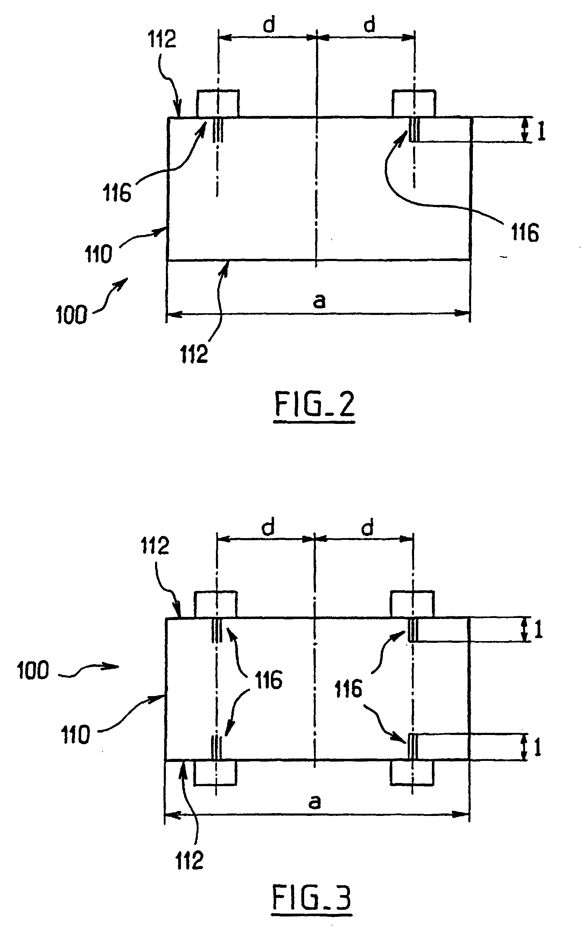

Dans le but de réduire encore davantage la longueur du dispositif 100, une autre variante complémentaire de l'invention consiste à disposer des paires d'antennes 116, comme dans la configuration précédente, en regard les unes des autres sur chacune des deux faces des grands côtés 112 du guide 110 comme cela est schématisé sur la Fig. 3. Cette possibilité est toutefois limitée en termes de conductance réalisable par le fait que les antennes 116 en regard ne doivent ni se toucher, ni être trop proches l'une de l'autre ; l'interaction entre antennes 116 en regard conduit à une augmentation de la conductance de chaque antenne 116.

Outre la configuration en guide rectangulaire 110 avec plan réflecteur 130 présentée ci-dessus, il est possible d'insérer la seule partie du guide rectangulaire 110 avec ses antennes 116 dans un résonateur en anneau. Dans ce cas, il convient de veiller à faire fonctionner le résonateur en mode d'ondes stationnaires (et non en mode d'ondes progressives) et s'assurer à l'aide de déphaseurs que la position des maxima de champ électrique des micro-ondes dans l'anneau correspond à la position des antennes 116 de couplage électrique.

Une autre variante de l'invention consiste à prélever la puissance sur le guide par des fentes, notamment dans le cadre d'une application à la transmission de puissance vers les sources de plasma 400 par des guides d'ondes.

Le deuxième élément 200 de l'invention est destiné à assurer une transmission de puissance indépendante et sans réflexion à chaque source 400. Ceci est réalisé par l'insertion entre la sortie de l'antenne 116 du guide diviseur 110 et l'applicateur, d'un isolateur unidirectionnel 200. Celui-ci est généralement constitué d'un circulateur 210 à trois branches réalisé à base de ferrites et terminé sur sa troisième branche par une charge adaptée 212 destinée à absorber toute puissance réfléchie en provenance de la source de plasma 400. Un bon fonctionnement de ce dispositif requiert une isolation entre branches généralement supérieure à 20 dB.

Le troisième élément 300 de l'invention est destiné à permettre l'adaptation d'impédance sur chaque source 400, afin d'assurer à la puissance ainsi disponible d'être plus ou moins totalement absorbée dans le plasma en fonction des besoins. Ceci peut être réalisé en faisant appel à des dispositifs classiques d'adaptation d'impédance comme le trombone coulissant, ou un système à trois pistons. Une caractéristique essentielle requise de ces différents dispositifs possibles est de pouvoir agir à la fois sur la partie imaginaire et la partie réelle de l'impédance. Ceci permet d'ajuster l'impédance de la source 400 en fonction des conditions plasma recherchées (densité, longueur, etc.).

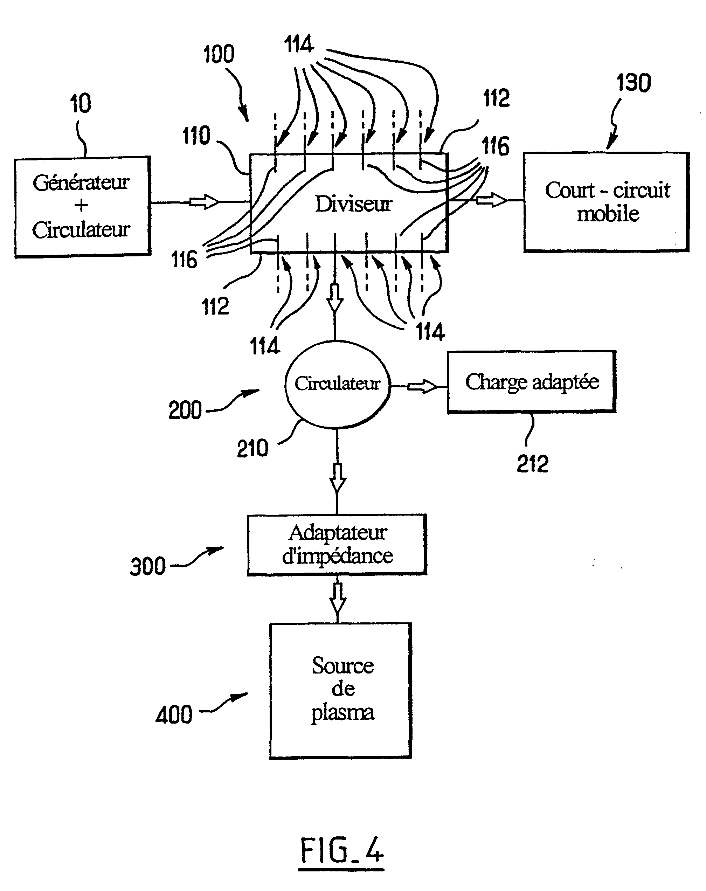

Un dispositif typique complet de division de puissance suivant l'invention est schématisé sur la Fig. 4. Après le générateur de micro-ondes 10, (et éventuellement son circulateur de protection), il comporte successivement le diviseur de puissance 100 avec son court-circuit mobile 130 et les lignes de transmission à chaque source de plasma 400. Chaque ligne de transmission comporte un circulateur 210 et sa charge adaptée 212 (qui absorbe la puissance réfléchie) ainsi que le dispositif d'adaptation d'impédance 300 juste en amont de la source de plasma 400.

L'intérêt principal du dispositif conforme à l'invention est de permettre l'alimentation d'un grand nombre de sources de plasma 400 à partir d'un générateur unique 10. Par ailleurs, la réalisation de ce dispositif s'effectue à partir d'éléments simples dont plusieurs sont disponibles de façon courante dans le commerce.

Un dispositif de l'invention peut être utilisé avec tout type d'applicateur de micro-ondes.

Un avantage essentiel de l'invention présentée est la possibilité de distribuer la puissance micro-onde sur un nombre N quelconque d'antennes 116, N pouvant même être un nombre impair. Egalement, l'invention autorise la suppression d'une ou plusieurs lignes de plasma sans altérer le fonctionnement des autres.

L'invention, qui permet d'éviter toute interférence entre les alimentations des diverses sources de plasma 400, rend possible de réaliser rapidement l'adaptation d'impédance sur chacune des sources de plasma 400.

Enfin, l'invention permet la réalisation de dispositifs particulièrement compacts.

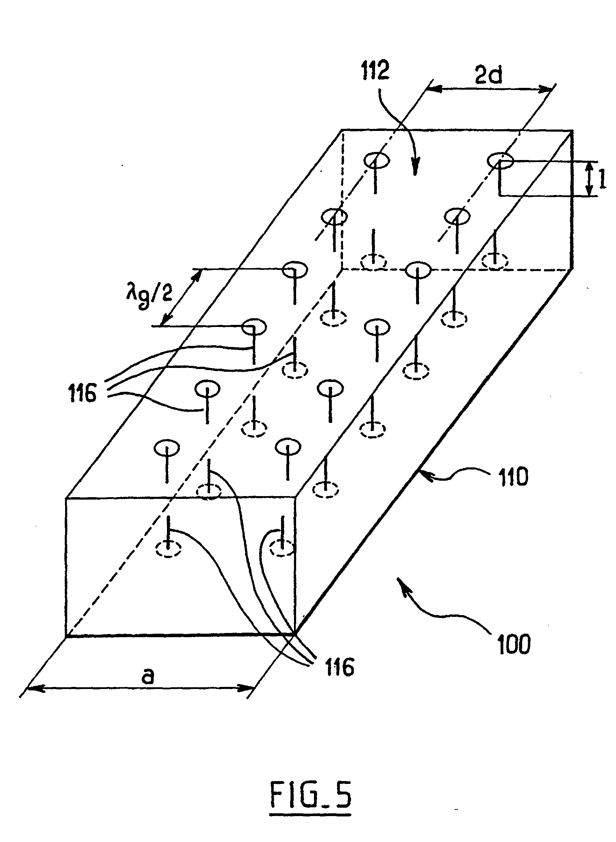

Un exemple d'application particulier, mais non limitatif, illustrant l'invention, comprend un dispositif de division de puissance par 24, (schématisé sur la Fig. 5), utilisant le standard de guide d'ondes rectangulaire WR 340 ou le grand côté 112 du guide 110 présente une largeur a = 86 mm (largeur du petit côté du guide b = 43 mm). A la fréquence de 2,45 GHz, la longueur d'onde dans le vide vaut $\lambda_0$ = 122,45 mm et la longueur d'onde dans le guide (Eq. 1) vaut :

$$\lambda_g = 174,4 \text{ mm} \qquad (4)$$

En conséquence, les antennes 116 ou groupes d'antennes sont positionnées le long du guide d'ondes 110 sous les $\lambda_g/2$, soit tous les 87,2 mm.

La conductance réduite g de l'antenne 116 (Eq. 2) pour une division égale par N = 24 requiert:

$$g = 0, 0417 \qquad (5)$$

La conductance correspondante $g_0$ d'une antenne 116 de même longueur $\ell$ placée sur l'axe d'un grand côté du guide (d = 0), donnée par l'Equation (3), vaut pour un écartement de l'axe du grand côté du guide d = 26 mm :

$$g_0 = 0, 123 \qquad (6)$$

L'impédance réduite $g_0$ d'une antenne 116 de longueur $\ell$, déterminée expérimentalement, est donnée sur la Fig. 1. La longueur d'antenne $\ell$ correspondant à la valeur d'impédance donnée par l'Equation (6) vaut approximativement (Fig. 1):

$$\ell = 12,75 \text{ mm.} \qquad (7)$$

En conséquence, le diviseur de puissance 100 par 24 ainsi réalisé, tel que schématisé sur la Fig. 5, est relativement compact puisque sa longueur totale correspond à 5 demi-longueurs d'ondes (plus l'encombrement des prises d'antennes et de leur connecteur coaxial).

Bien entendu, chacune des 24 lignes de transmission issues du diviseur 100 comporte successivement un isolateur 200 avec sa charge adaptée 212 et l'adaptation d'impédance 300 juste en amont de la source de plasma 400.

En dehors des plasmas, le dispositif conforme à l'invention peut être appliqué dans tous les procédés où des variations d'impédance peuvent se produire sur l'un ou l'autre des N applicateurs alimentés de façon indépendante par le diviseur de puissance micro-onde.

Bien entendu, la présente invention n'est pas limitée aux modes de réalisation particuliers qui viennent d'être décrits.

Ainsi en variante on peut prévoir une disposition des antennes non symétrique par rapport à l'axe du grand côté du guide.

**Revendications**

1. Système micro-ondes comprenant :

   - un générateur de micro-ondes (10),
   - un guide rectangulaire (110) couplé au générateur (10), adapté pour fonctionner en mode fondamental ($H_{10}$) ou transversal électrique ($TE_{10}$), et associé à des moyens assurant un régime d'ondes stationnaires,
   - une pluralité de prises de puissance (116) disposées dans le guide (110) au niveau des zones d'amplitude maximale de l'une des composantes du champ électromagnétique pour assurer une division de la puissance du générateur (10),

   **caractérise par le fait que** les prises de puissance (116) sont ajustées de telle sorte que la somme de leurs admittances réduites ramenées à rentrée du diviseur formé par le guide rectangulaire (110), soit unitaire

   - une pluralité de sources (400), sont couplées respectivement à une prise (116) du guide (110), par l'intermédiaire
   - d'un moyen isolateur (200) assurant une transmission de puissance de la prise (116) vers la source (400), sans réflexion vers la prise (116) et

- un dispositif (300) d'adaptation d'impédance de chaque source (400), est situé en aval du moyen isolateur (200), entre ce dernier et ta source associée (400).

2. Système selon la revendication 1, **caractérisé par le fait que** l'une au moins des sources (400) est une source de plasma.

3. Système selon l'une des revendications 1 ou 2, **caractérisé par le fait que** le guide (110) comporte un plan réflecteur (130) formant court-circuit fixe ou mobile pour assurer une condition d'onde stationnaire.

4. Système selon rune des revendications 1 ou 2, **caractérisé par le fait que** le guide rectangulaire (110) avec ses prises (116) est placé dans un résonateur en anneau.

5. Système selon l'une des revendications 1 à 4, **caractérisé par le fait que** les prises de puissance sont formées d'antennes électriques situées au maximum de l'intensité de champ électrique.

6. Système selon l'une des revendications 1 à 4, **caractérisé par le fait que** les prises de puissance (116) sont formées d'antennes magnétiques situées au minimum d'intensité de champ électrique.

7. Système selon l'une des revendications 1 à 4, **caractérisé par le fait que** les prises de puissances (116) sont formées de fentes.

8. Système selon l'une des revendications 1 à 7, **caractérisé par le fait que** les prises de puissance (116) sont situées sur un grand côté (112) du guide (110).

9. Système selon l'une des revendications 1 à 8, **caractérisé par le fait que** les prises de puissance (116) sont distantes d'une demi-longueur d'onde ($\lambda_g$/2) dans le guide (110).

10. Système selon l'une des revendications 1 à 9, **caractérisé par le fait qu'**il comprend au moins une paire d'antennes (116) disposées respectivement de part et d'autre de l'axe du grand côté (112) du guide (110).

11. Système selon l'une des revendications 1 à 10, **caractérisé par le fait qu'**il comprend au moins une paire d'antennes (116) disposées respectivement de part et d'autre de l'axe du grand côté (112) du guide (110), de façon symétrique.

12. Système selon l'une des revendications 1 à 11, **caractérisé par le fait qu'**il comprend au moins une paire d'antennes (116) disposées respectivement de part et d'autre de l'axe d'un grand côté (112) du guide (110), respectivement sur chacun des grands côtés (112) du guide.

13. Système selon l'une des revendications 1 à 12, **caractérisé par le fait qu'**il comprend au moins une paire d'antennes (116) disposées de façon symétrique respectivement de part et d'autre de l'axe d'un grand côté (112) du guide (110), respectivement sur chacun des grands côtés (112) du guide.

14. Système selon l'une des revendications 1 à 13, **caractérisé par le fait que** le moyen isolateur (200) est constitué d'un circulateur (210) à trois branches, associé sur l'une des branches à une charge adaptée (212).

15. Système selon l'une des revendications 1 à 14, **caractérisé par le fait que** le dispositif d'adaptation d'impédance (300) est choisi dans le groupe comprenant un trombone coulissant ou un système à trois pistons.

16. Système selon l'une des revendications 1 à 15, **caractérisé par le fait que** pour une division égale de la puissance micro-onde par N, il est prévu N antennes (116) de conductance réduite identique, égale, ramenée à l'entrée du guide, à g = 1/N.

**Patentansprüche**

1. Mikrowellensystem, das folgendes umfaßt:

 - einen Mikrowellengenerator (10),
 - einen mit dem Generator (10) gekoppelten rechteckförmigen Leiter (110), der zum Arbeiten in einem Grundmodus ($H_{10}$) oder transversal elektrischem Modus ($TE_{10}$) ausgestaltet ist, und Mitteln zugehört, die ein Verhalten stehender Wellen sicherstellen,
 - mehrere Leistungsaufnehmer (116), die im Leiter (110) in Höhe von Zonen maximaler Amplitude von einer der Komponenten des elektromagnetischen Feldes angeordnet sind, um eine Aufteilung der Leistung des Generators (10) sicherzustellen,

 **dadurch gekennzeichnet, daß**
 die Leistungsaufnehmer (116) derart abgeglichen sind, daß die Summe ihrer reduzierten Leitwerte, die am Eingang des durch den rechteckförmigen Leiter (110) gebildeten Teilers zusammengeführt sind, unitär ist,

- mehrere Quellen (400), die jeweils mit einem Aufnehmer (116) des Leiters (110) gekoppelt sind, mittels
- eines Isolatormittels (200), das eine Leistungsübertragung vom Aufnehmer (116) in Richtung der Quelle (400) sicherstellt, ohne Reflexion in Richtung des Aufnehmers (116),
- wobei eine Einrichtung (300) zum Anpassen der Impedanz jeder Quelle (400) stromab des Isolatormittels (200) zwischen dem letzteren und der zugehörigen Quelle (400) gelegen ist.

2. System nach Anspruch 1, **dadurch gekennzeichnet, daß** wenigstens eine der Quellen (400) eine Plasmaquelle ist.

3. System nach einem der Ansprüche 1 oder 2, **dadurch gekennzeichnet, daß** der Leiter (110) einen ebenen Reflektor (130) umfaßt, der einen festen oder mobilen Kurzschluß bildet, um einen Zustand stehender Wellen sicherzustellen.

4. System nach einem der Ansprüche 1 oder 2, **dadurch gekennzeichnet, daß** der rechteckförmige Leiter (110) mit seinen Aufnehmern (116) in einem Ringresonator plaziert ist.

5. System nach einem der Ansprüche 1 bis 4, **dadurch gekennzeichnet, daß** die Leistungsaufnehmer aus elektrischen Antennen gebildet sind, die im Intensitätsmaximum des elektrischen Feldes gelegen sind.

6. System nach einem der Ansprüche 1 bis 4, **dadurch gekennzeichnet, daß** die Leistungsaufnehmer (116) aus magnetischen Antennen gebildet sind, die im Intensitätsminimum des elektrischen Feldes gelegen sind.

7. System nach einem der Ansprüche 1 bis 4, **dadurch gekennzeichnet, daß** die Leistungsaufnehmer (116) aus Schlitzen gebildet sind.

8. System nach einem der Ansprüche 1 bis 7, **dadurch gekennzeichnet, daß** die Leistungsaufnehmer (116) an einer großen Seite (112) des Leiters (110) gelegen sind.

9. System nach einem der Ansprüche 1 bis 8, **dadurch gekennzeichnet, daß** die Leistungsaufnehmer (116) im Leiter (110) um eine halbe Wellenlänge ($\lambda_g/2$) beabstandet sind.

10. System nach einem der Ansprüche 1 bis 9, **dadurch gekennzeichnet, daß** es wenigstens ein Paar Antennen (116) umfaßt, die auf der einen bzw. der anderen Seite der Achse der großen Seite (112) des Leiters (110) angeordnet sind.

11. System nach einem der Ansprüche 1 bis 10, **dadurch gekennzeichnet, daß** es wenigstens ein Paar Antennen (116) umfaßt, die symmetrisch auf der einen bzw. der anderen Seite der Achse der großen Seite (112) des Leiters (110) angeordnet sind.

12. System nach einem der Ansprüche 1 bis 11, **dadurch gekennzeichnet, daß** es wenigstens ein Paar Antennen (116) aufweist, die auf der einen bzw. der anderen Seite der Achse einer großen Seite (112) des Leiters (110) angeordnet sind, jeweils auf jeder der großen Seiten (112) des Leiters.

13. System nach einem der Ansprüche 1 bis 12, **dadurch gekennzeichnet, daß** es wenigstens ein Paar Antennen (116) aufweist, die symmetrisch auf der einen bzw. der anderen Seite der Achse einer großen Seite (112) des Leiters (110) angeordnet sind, jeweils auf jeder der großen Seiten (112) des Leiters.

14. System nach einem der Ansprüche 1 bis 13, **dadurch gekennzeichnet, daß** das Isolatormittel (200) aus einem Zirkulator (210) mit drei Zweigen gebildet ist, der mit einem seiner Zweige einer angepaßten Last (212) zugehört.

15. System nach einem der Ansprüche 1 bis 14, **dadurch gekennzeichnet, daß** die Impedanzanpassungseinrichtung (300) aus der Gruppe ausgewählt ist, die einen hinund herbewegbaren Schleifendipol oder ein System mit drei Kolben umfaßt.

16. System nach einem der Ansprüche 1 bis 15, **dadurch gekennzeichnet, daß** für eine gleiche Aufteilung der Mikrowellenleistung durch N gleich N identische Antennen mit verminderter Leitfähigkeit vorgesehen sind, die am Eingang des Leiters zusammengeführt sind, mit g = 1/N.

**Claims**

1. Microwave system comprising:

   - a microwave generator (10);
   - a rectangular waveguide (110) coupled to the generator (10), matched in order to operate in the fundamental mode ($H_{10}$) or in the transverse electric mode ($TE_{10}$), and combined with means ensuring standing wave conditions;
   - a plurality of power output ports (116) placed in the waveguide (110) in the regions of maximum amplitude of one of the components of the electromagnetic field in order to provide power division for the generator (10),

   **characterized in that** the power output ports (116) are adjusted in such a way that the sum of their reduced admittances brought back to the input of the divider formed by the rectangular waveguide (110) is unitary

- a plurality of sources (400) are coupled respectively to an output port (116) of the waveguide (110) by the agency
- of an isolator means (200) ensuring power transmission from the output port (116) to the source (400), without being reflected back to the output port (116), and
- a device (300) for matching the impedance of each source (400) is located downstream of the isolator means (200), between the latter and the associated source (400).

2. System according to Claim 1, **characterized in that** at least one of the sources (400) is a plasma source.

3. System according to either of Claims 1 and 2, **characterized in that** the waveguide (110) includes a reflecting plane (130) forming a fixed or movable short-circuit in order to fulfil a standing wave condition.

4. System according to either of Claims 1 and 2, **characterized in that** the rectangular waveguide (110) with its output ports (116) is placed in a ring resonator.

5. System according to one of Claims 1 to 4, **characterized in that** the power output ports are formed from electrical antennas located at the maximum of the electric field intensity.

6. System according to one of Claims 1 to 4, **characterized in that** the power output ports (116) are formed from magnetic antennas located at the electric field intensity minimum.

7. System according to one of Claims 1 to 4, **characterized in that** the power output ports (116) are formed by slots.

8. System according to one of Claims 1 to 7, **characterized in that** the power output ports (116) are located on a long side (112) of the waveguide (110).

9. System according to one of Claims 1 to 8, **characterized in that** the power output ports (116) are separated by half of the wavelength ($\lambda_g/2$) in the waveguide (110).

10. System according to one of Claims 1 to 9, **characterized in that** it includes at least one pair of antennas (116) placed respectively on either side of the axis of the long side (112) of the waveguide (110).

11. System according to one of Claims 1 to 10, **characterized in that** it includes at least one pair of antennas (116) which are placed respectively on either side of the axis of the long side (112) of the waveguide (110) in a symmetrical manner.

12. System according to one of Claims 1 to 11, **characterized in that** it includes at least one pair of antennas (116) which are placed respectively on either side of the axis of a long side (112) of the waveguide (110), respectively on each of the long sides (112) of the waveguide.

13. System according to one of Claims 1 to 12, **characterized in that** it includes at least one pair of antennas (116) which are placed in a symmetric manner respectively on either side of the axis of a long side (112) of the waveguide (110), respectively on each of the long sides (112) of the waveguide.

14. System according to one of Claims 1 to 13, **characterized in that** the isolator means (200) consists of a three-branch circulator (210), which is combined with a matched load (212) on one of the branches.

15. System according to one of Claims 1 to 14, **characterized in that** the impedance matching device (300) is chosen from the group comprising a trombone line or a system having three plungers.

16. System according to one of Claims 1 to 15, **characterized in that**, for the microwave power to be split equally N ways, N antennas (116) of identical reduced conductance are provided, each conductance, taken back to the input of the waveguide, being equal to g = 1/N.

FIG.1

FIG. 2

FIG. 3

FIG.4

FIG_5